# EUROPÄISCHE PATENTSCHRIFT

(11) **EP 0 853 242 B1**
(45) Veröffentlichungstag und Bekanntmachung des Hinweises auf die Patenterteilung: **10.03.2004**
(21) Anmeldenummer: 98100304.9
(22) Anmeldetag: 09.01.1998
(51) Int. Cl.: G01R 31/28

(54) **Verfahren zum Prüfen von Leiterplatten**
Method for testing printed-circuit boards
Procédé pour tester des cartes de circuits imprimés

(30) Priorität: 09.01.1997 DE 19700505
(43) Veröffentlichungstag der Anmeldung: 15.07.1998
(73) Patentinhaber: atg test systems GmbH & Co. KG, 97877 Wertheim (DE)
(72) Erfinder: Huth, Ralf, 72800 Eningen (DE); Rothaug, Uwe, 97828 Marktheidenfeld (DE)
(74) Vertreter: Ganahl, Bernhard

(56) Entgegenhaltungen:
- EP-A- 0 468 153
- DE-A- 3 900 040
- US-A- 5 187 430
- LEFERINK ET AL.: "INDUCTANCE OF PRINTED CIRCUIT BOARD GROUND PLANES" 1993 INT. SYMPOSIUM ON ELECTROMAGNETIC COMPATIBILITY, 9. - 13.August 1993, DALLAS, TEXAS, Seiten 327-329, XP000427693
- HÖHN ET AL.: "VD 20IP 70, ein Prüfautomat für umfangreiche Verdrahtungen" SIEMENS ZEITSCHRIFT, Bd. 44, Nr. 11, 1970, Seiten 676-679, XP002060014

## Beschreibung

Die Erfindung betrifft ein Verfahren zum Prüfen von Leiterplatten.

Leiterplatten weisen eine Vielzahl von Leiterbahnen auf, wobei deren Dichte auf den Leiterplatten sich mit der kontinuierlich fortschreitenden Miniaturisierung der elektronischen Bauelemente zunehmend erhöht.

Bekannte Vorrichtungen zum Prüfen von Leiterplatten können grundsätzlich in zwei Gruppen eingeteilt werden. Zur ersten Gruppe gehören die Vorrichtungen mit Adapter, bei welchen alle Prüfpunkte einer Leiterplatte gleichzeitig mittels des Adapters kontaktiert werden. Die zweite Gruppe umfaßt die sogenannten Fingertester. Das sind Vorrichtungen, die mit zwei oder mehreren Prüffingern die einzelnen Prüfpunkte sequentiell abtasten.

Fingertester sind bspw. aus der EP 0 468 153 A1 bekannt.

Unabhängig von der Art der Vorrichtung werden die einzelnen Leiterbahnen auf Unterbrechungen in den Leiterbahnen ("Unterbrechungstest") und auf elektrische Verbindungen zu anderen Leiterbahnen ("Kurzschlußtest") getestet. Der Kurzschlußtest kann sowohl die Detektion von niederohmigen als auch von hochohmigen Verbindungen umfassen.

Sowohl für den Unterbrechungstest als auch für den Kurzschlußtest sind unterschiedliche Meßverfahren bekannt. Hierbei wird jede Leiterbahn auf einen Kurzschluß bzw. jeder Zweig einer Leiterbahn auf eine Unterbrechung untersucht, so daß bei modernen Leiterplatten mit einer Vielzahl von Leiterbahnen eine entsprechend hohe Anzahl einzelner Meßvorgänge durchgeführt werden muß.

Man hat versucht, die einzelnen Meßvorgänge zu optimieren und deren Anzahl zu minimieren, wobei eine Vielzahl unterschiedlicher Verfahren vorgeschlagen und umgesetzt worden sind. So werden insbesondere Kurzschlußtests mit teilweise sehr hohen Spannungen durchgeführt, da auch bei hohen Spannungen keine temporären Verbindungen zwischen den einzelnen Leiterbahnen entstehen sollen. Hierdurch wird eine hohe Sicherheit für den Dauerbetrieb gewährleistet.

Ferner ist aus der US 5,202,640 ein Fingertester bekannt, der auf einer Seite der zu prüfenden Leiterplatte zwei Testfinger zum Abgreifen der Meßspannungen bzw. Meßströme und auf der zu den Testfingern gegenüberliegenden Seite der zu prüfenden Leiterplatte eine feststehende Elektrode aufweist, mit welcher an einer leitenden Ebene eine hohe Spannung zur Durchführung von Kapazitätstests angelegt werden kann. Als leitende Ebene kann eine zusätzliche, angrenzend an der Leiterplatte angeordnete Referenzplatte vorgesehen sein, oder es können auch Power-Leiterbahnen und Ground-Leiterbahnen miteinander kurzgeschlossen sein, die oftmals als flächige Elemente ausgebildet sind. Durch das Kurzschließen der flächigen Power und Ground-Leiterbahnen kann somit eine Referenzebene ohne zusätzlicher Platte vorgesehen werden. Diese Ausbildung einer ebenflächigen Elektrode vermindert den Einfluß von Streukapazitäten.

Aus der DE 39 00 040 A1 geht ein Verfahren zum elektrischen Prüfen von Leiterbahnen hervor, bei welchem mehrere auf einem Substrat angeordnete Leiterbahnen mittels eines Leitgummistreifens elektrisch miteinander verbunden werden. Die übrigen Leiterbahnen werden dann gegenüber dieser Gruppe von Leiterbahnen auf Kurzschluss getestet. Mit diesem Verfahren soll eine Zeitersparnis erreicht werden.

Der Erfindung liegt die Aufgabe zugrunde, ein einfaches Verfahren zum Prüfen von Leiterplatten zu schaffen, mit dem Leiterplatten schnell bei hoher Zuverlässigkeit getestet werden können.

Die Aufgabe wird durch ein Verfahren mit den Merkmalen des Anspruchs 1 gelöst. Vorteilhafte Ausgestaltungen sind in den Unteransprüchen angegeben.

Der Erfindung liegt die Erkenntnis zugrunde, daß es mit herkömmlichen, niedrigen Testspannungen kaum möglich ist, sogenannte Pseudo-Kurzschlüsse zu finden, die durch Übersprechen zwischen zwei Leiterbahnen erzeugt werden, weshalb hohe Meßspannungen von z.B. 250 V oder 500 V angelegt werden müssen. Derartig hohe Spannungen können jedoch bei größeren Leiterbahnen nicht schlagartig angelegt werden, da diese eine Gegeninduktivität aufweisen, welche den maximalen Strom und damit die maximale Spannungsänderung begrenzt. Größere Leiterbahnen im Sinne der Erfindung sind z.B. Leiterbahnen mit einer Induktivität von mehr als 0,1 mH, vorzugsweise 1 mH bis 5 mH, mehr als 10 Kontaktpunkten oder einer Kapazität von mehr als 10 pF.

Erfindungsgemäß werden deshalb eine Gruppe, bestehend vorzugsweise aus solchen größeren Leiterbahnen mittels elektrisch miteinander verbundener Testfinger eines Fingertesters kurzgeschlossen. Die Prüfspannung wird dann an allen miteinander kurzgeschlossenen Leiterbahnen gleichzeitig hochgefahren, wodurch sich eine erhebliche Zeiteinsparung gegenüber einem Einzeltest ergibt. Das Kurzschließen mittels der Testfinger ist einfach ohne zusätzliche Hardware an herkömmlichen Fingertestern durchführbar, da die zum Kurzschließen verwendeten Testfinger lediglich zueinander elektrisch durchgeschaltet werden müssen und während des Meßvorgangs permanent mit der jeweiligen kurzgeschlossenen Leiterbahn in Kontakt verbleiben. Bei einem Meßvorgang werden in der Regel eine Vielzahl weiterer Leiterbahnen der Reihe nach gegen die miteinander kurzgeschlossene Gruppe von Leiterbahnen getestet, so daß während des Meßverfahrens lediglich die die weiteren Leiterbahnen kontaktierenden Testfinger bewegt werden. Da die weiteren Leiterbahnen gegenüber der gesamten Gruppe von kurzgeschlossenen Leiterbahnen getestet werden und nicht gegenüber jeder Leiterbahn aus der Gruppe einzeln getestet werden müssen, ergibt sich eine wesentliche Zeitersparung.

Vorzugsweise werden die zu einer Gruppe kurzgeschlossenen Leiterbahnen vorab untereinander auf Kurzschluß getestet.

Mit einem Fingertester mit mehreren Testfingern, insbesondere zumindest vier oder vorzugsweise acht oder mehr Testfingern, kann durch das erfindungsgemäße Verfahren im Vergleich zu herkömmlichen Testverfahren viel schneller und bei einer höheren Meßsicherheit ein Hochspannungstest durchgeführt werden, wobei sich durch den Stillstand der mit der Gruppe von kurzgeschlossenen Leiterbahnen in Verbindung stehende Testfinger während eines Testvorgangs zudem eine wesentliche Vereinfachung ihrer Bewegungssteuerung ergibt.

Das erfindungsgemäße Verfahren erlaubt bei Fingertestern mit mehreren Testfingern die Durchführung von Hochspannungstests mit einer wesentlichen Zeitreduktion bei gleichzeitiger Vereinfachung der Bewegungsabläufe der Testfinger, da während eines Meßvorgangs die mit den kurzgeschlossenen Leiterbahnen in Kontakt stehenden Testfinger nicht bewegt werden.

Beim erfindungsgemäßen Verfahren können auch mehrere Gruppen von Leiterbahnen nacheinander kurzgeschlossen werden und jeweils als Gruppe gegenüber den übrigen Leiterbahnen getestet werden, wobei vorzugsweise in den Gruppen von kurzgeschlossenen Leiterbahnen jeweils die größeren Leiterbahnen der Leiterplatte zusammengefaßt bzw. kurzgeschlossen sind.

Vorzugsweise umfaßt die Gruppe miteinander kurzgeschlossener Leiterbahnen Power-Leiterbahnen und Ground-Leiterbahnen, da diese im Vergleich zu den übrigen Signalleiterbahnen groß ausgebildet sind und eine entsprechend hohe Induktivität aufweisen. Der Test von Power-Leiterbahnen gegenüber Ground-Leiterbahnen ist sehr wichtig, da ein Kurzschluß zwischen Power- und Ground-Leiterbahnen, insbesondere in Verbindung mit Signalleiterbahnen, Bauteile einer Leiterplatte zerstören kann.

Bei modernen Leiterplatten sind in der Regel nicht mehr als fünf Power- oder Ground-Leiterbahnen vorhanden, die sich üblicherweise über die gesamte Länge oder Breite der Leiterplatte erstrecken.

Die angewandte Prüfspannung beträgt bspw. 250 V, vorzugsweise 500 V. Mit derartig hohen Spannungen lassen sich Widerstände im Giga-Ohm-Bereich messen.

Nachfolgend wird die Erfindung anhand beigefügter Zeichnungen näher erläutert. In den zeigen schematisch:
- Fig.1: eine Draufsicht auf einen Fingertester,
- Fig. 2: eine Seitenansicht des Fingertesters aus Fig. 1, und

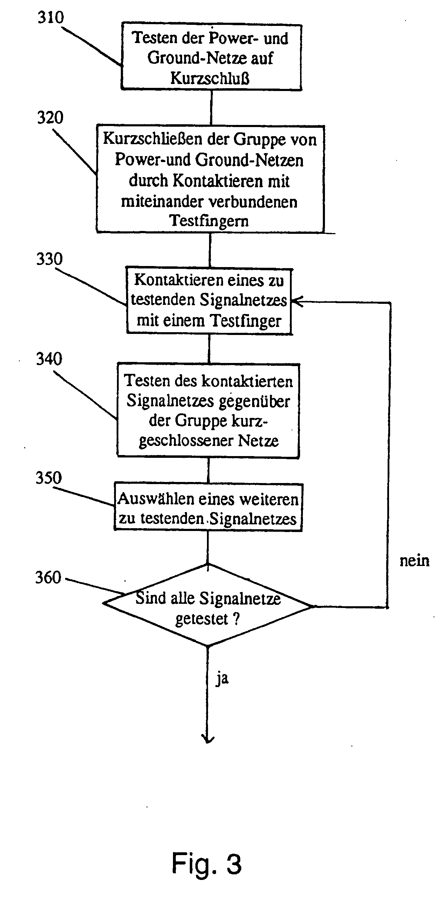

- Fig. 3: ein Flußdiagramm.

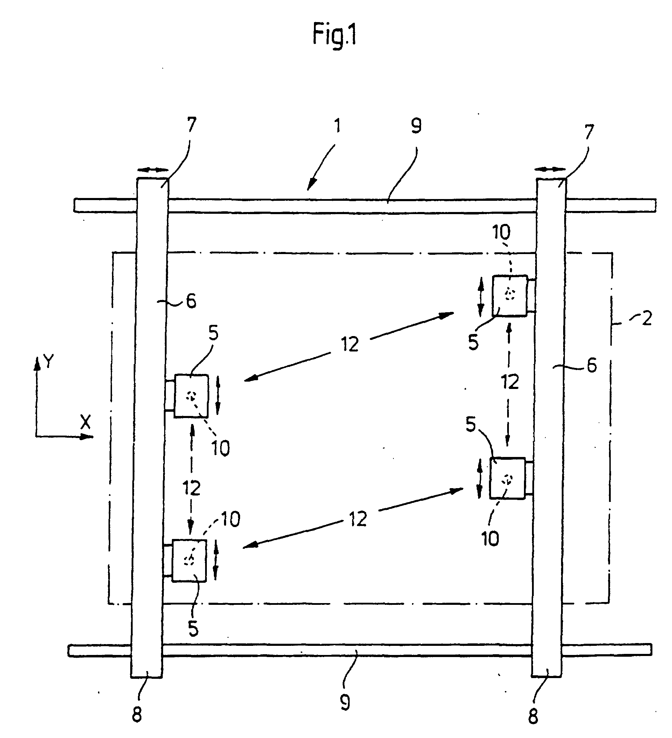

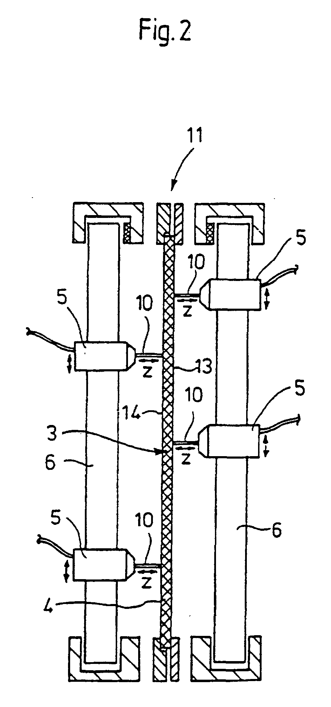

Der in Fig.1 und 2 gezeigte Fingertester 1 weist ein Prüffeld 2 auf, das zur Aufnahme des Prüflings 3, der in der Regel eine Leiterplatte 4 ist, dient. Seitlich vom Prüffeld 2 sind zwei Führungen 9 angeordnet, auf welchen Traversen 6 mit ihren Endabschnitten 7, 8 lagern. Die Traversen sind auf den Führungen 9 in X-Richtung verfahrbar.

An den Traversen sind Positionierglieder 5 angeordnet, die entlang der Traversen 6 und somit in Y-Richtung verfahrbar sind. Auf jeder Traverse 6 sind zwei Positionierglieder vorgesehen. Auf einem Paar von Führungen 9 lagern zwei Traversen 6. Diese Prüfeinheit bestehend aus den Führungen 9, den Traversen 6 und den Positioniergliedern 5 ist zweifach, nämlich auf jeder Seite des Prüffeldes 2 einmal ausgebildet.

Die Positionierglieder 5 sind jeweils mit einem zum Prüffeld 2 weisenden Kontaktfinger 10 versehen, der aus dem Positionierglied 5 in Richtung zum Prüffeld 2 und somit in Z-Richtung verstellbar ist.

Zwischen den beiden Prüfeinheiten ist die zu prüfende Leiterplatte 4 mittels Befestigungsmittel 11 gehalten.

Im nachfolgend erläuterten Ausführungsbeispiel wird von einer Leiterplatte 4 mit insgesamt fünf Power- und Ground-Leiterbahnen ausgegangen.

Es werden alle Power- und Ground-Leiterbahnen gegeneinander mit Hochspannung auf Kurzschluß getestet (Schritt 310). Dieser Test wird auch als Isolationstest bezeichnet. Bei einer Testspannung von 500 V dauert aufgrund der auftretenden Gegeninduktivitäten das Hoch- und Runterfahren der Spannung etwa 30 Sekunden. Zum Testen aller fünf Power- bzw. Ground-Leiterbahnen werden insgesamt 10 Tests benötigt, so daß diese Tests etwa 300 Sekunden dauern.

Zum Test der Power- bzw. Ground-Leiterbahnen gegenüber allen Signalleiterbahnen werden mehrere der Power- und/oder Ground-Leiterbahnen miteinander kurzgeschlossen (Schritt 320) und jede Signalleiterbahn mit hoher Testspannung von bspw. 500 V gegenüber dieser Gruppe von Power- und/oder Ground-Leiterbahnen getestet (Schritte 330 bis 360).

Das temporäre Verbinden (=gezielter Kurzschluß) der Powerund/oder Groundleiterbahnen erfolgt über Testfinger, die mit den jeweiligen Power- bzw. Ground-Leiterbahnen in Kontakt stehen und untereinander elektrisch verbunden sind (Schritt 320).

Weist die zu testende Leiterplatte 2.000 Signalleiterbahnen auf, so benötigt man 2.000 Messungen (Schritt 340), um jede Signalleiterbahn gegenüber der Gruppe von kurzgeschlossenen Leiterbahnen zu testen. Die angelegte Meßspannung wird auf die Gruppe von kurzgeschlossenen Leiterbahnen und den einzelnen Signalleiterbahnen zu jeweils 250 V aufgeteilt. Dies ist in der Regel aus leitungstechnischen Gründen notwendig, da die meisten Fingertester nicht für absolute Spannungen bis 500 V ausgelegt sind. An die Gruppe von kurzgeschlossenen Power- und Ground-Leiterbahnen wird z.B. eine Meßspannung von +250 V angelegt. Diese Meßspannung wird nur ein einziges Mal nach dem Kurzschließen beim Schritt 320 hochgefahren und für den gesamten Meßvorgang konstant gehalten. Während der einzelnen Messungen wird dann lediglich eine Spannung von z.B. -250 V an die einzelnen zu testenden Signalleiterbahnen angelegt (Schritt 340). Bei einer gesamten Prüfspannung von 500 V dauert jede einzelne Messung in Abhängigkeit von der Größe der zu testenden Signalleiterbahn etwa 15 bis 20 Sekunden. Diese Zeit wird zum Umsetzen der Testfinger (Schritt 330) und zum Hoch- und Runterfahren der an den Signalleiterbahnen anliegenden Spannungen benötigt.

Die gesamte Meßzeit liegt somit im Bereich von etwa 30.000 bis 40.000 Sekunden.

Bei Prüfspannungen bis 250 V oder bei einer auf die maximale Prüfspannung abgestimmten Dimensionierung der Leitungen und der Elektronik kann an die Gruppe von kurzgeschlossenen Power- und Ground-Leiterbahnen die gesamte Prüfspannung gegenüber Masse angelegt und die Signalleiterbahnen mit einem mit Masse elektrisch verbundenen Testfinger getestet werden. Dieser mit Masse verbundene Testfinger kann ohne jeweiligem Hochfahren der Prüfspannung zwischen den einzelnen Signalleiterbahnen in Bruchteilen von Sekunden versetzt werden. Hierdurch ergibt sich eine weitere drastische Reduzierung der Meßzeit.

Würde man in herkömmlicher Weise gegen jede Power-Leiterbahn bzw. Ground-Leiterbahn einzeln messen, so würde man insgesamt 10.000 Messungen benötigen. Bei einer Prüfspannung von nur 250 V würde jede einzelne Messung etwa 10 Sekunden dauern. Die gesamte Meßzeit würde somit etwa 100.000 Sekunden betragen. Bei diesen Meßdaten wird vorausgesetzt, daß die gesamte Meßspannung von 250 V jeweils zur Hälfte (+ 125 V) auf die Power- bzw. Ground-Leiterbahn und zur Hälfte (- 125 V) auf die zu testende Signalleiterbahn aufgeteilt wird.

Mit dem erfindungsgemäßen Meßverfahren kann somit in kürzerer Zeit mit einer höheren Prüfspannung getestet werden. Durch das erfindungsgemäße Verfahren wird deshalb sowohl die Meßzeit verringert als auch die Zuverlässigkeit der Messungen erhöht.

Zudem wird bei Fingertestern eine Wegoptimierung erzielt, da die die Power- und Ground-Leiterbahnen kurzschließenden Testfinger nicht bewegt werden müssen.

Beim Ausführungsbeispiel ist eine Gruppe aus Power- und Ground-Leiterbahnen kurzgeschlossen. Die Erfindung ist jedoch nicht auf diese eine spezielle Gruppe beschränkt. Es können beliebige Leiterbahnen miteinander kurzgeschlossen werden; vorzugsweise sind die größeren Leiterbahnen einer Leiterplatte zu einer Gruppe zusammengefaßt. Es können auch mehrere Gruppen von Leiterbahnen gebildet werden, die der Reihe nach gegen die restlichen Leiterbahnen getestet werden.

## Patentansprüche

1. Verfahren zum Prüfen von Leiterplatten mit einer Vielzahl von Leiterbahnen, wobei eine Gruppe von Leiterbahnen einer Leiterplatte durch Anlegen von elektrisch miteinander verbundenen Testfingern kurzgeschlossen werden, und durch Anlegen einer Prüfspannung von zumindest 250 V an die Gruppe von Leiterbahnen weitere Leiterbahnen auf Kurzschluß gegenüber dieser Gruppe von Leiterbahnen getestet werden.

2. Verfahren nach Anspruch 1,
**dadurch gekennzeichnet,**
**daß** die mittels der Testfinger kurzgeschlossenen Leiterbahnen eine Induktivität von zumindest 0,1 mH aufweisen.

3. Verfahren nach Anspruch 1,
**dadurch gekennzeichnet,**
**daß** die mittels der Testfinger kurzgeschlossenen Leiterbahnen eine Induktivität von zumindest 1 mH aufweisen.

4. Verfahren nach einem der Ansprüche 1 bis 3,
**dadurch gekennzeichnet,**
**daß** die mittels der Testfinger kurzgeschlossenen Leiterbahnen eine Kapazität von zumindest 10 pF aufweisen.

5. Verfahren nach einem der Ansprüche 1 bis 4,
**dadurch gekennzeichnet,**
**daß** die mittels der Testfinger kurzgeschlossenen Leiterbahnen zumindest 10 Kontaktpunkte aufweisen.

6. Verfahren nach einem der Ansprüche 1 bis 5,
**dadurch gekennzeichnet,**
**daß** die mittels der Testfinger kurzgeschlossenen Leiterbahnen eine Kapazität von zumindest 1 µF aufweisen.

7. Verfahren nach Anspruch 1 oder 6,
**dadurch gekennzeichnet,**
**daß** die mittels der Testfinger kurzgeschlossenen Leiterbahnen Power-Leiterbahnen und/oder Ground-Leiterbahnen sind.

8. Verfahren nach einem der Ansprüche 1 bis 7,
**dadurch gekennzeichnet,**
**daß** die Prüfspannung 500 V beträgt.

9. Verfahren nach einem der Ansprüche 1 bis 8,
**dadurch gekennzeichnet,**
**daß** an die Gruppe von kurzgeschlossenen Leiterbahnen die Prüfspannung gegenüber Masse angelegt wird. und die weiteren Leiterbahnen mit einem mit Masse elektrisch verbundenen Testfinger getestet werden.

10. Verfahren nach einem der Ansprüche 1 bis 9,
**dadurch gekennzeichnet,**
**daß** vor dem Kurzschließen der Gruppe von kurzzuschließenden Leiterbahnen die einzelnen Leiterbahnen dieser Gruppe untereinander gegenseitig einzeln auf Kurzschluß getestet werden.

## Claims

1. A method of testing circuit boards including a plurality of conductor tracks, wherein
an array of conductor tracks of a circuit board are short-circuited by applying test fingers electrically connected to each other and
by applying a test voltage of at least 250 V to the array of conductor tracks, further conductor tracks are short-circuit-tested relative to said array of conductor tracks.

2. The method as set forth in claim 1, wherein
said circuits short-circuited by means of said test fingers comprise an inductance of at least 0.1 mH.

3. The method as set forth in claim 1, wherein
said circuits short-circuited by means of said test fingers comprise an inductance of at least 1 mH.

4. The method as set forth in claim 1 to 3, wherein
said circuits short-circuited by means of said test fingers comprise a capacitance of at least 10 pF.

5. The method as set forth in claim 1 to 4, wherein
said circuits short-circuited by means of said test fingers comprise at least 10 contact points.

6. The method as set forth in claim 1 to 5, wherein
said circuits short-circuited by means of said test fingers comprise a capacitance of at least 1 mF.

7. The method as set forth in claim 1 or 6, wherein
said circuits short-circuited by means of said test fingers are power circuits and/or ground circuits.

8. The method as set forth in claim 1 to 7, wherein
said test voltage is at least 500 V.

9. The method as set forth in claim 1 to 8, wherein
said test voltage is applied to said shorted circuit array relative to ground and said further circuits are tested with a test finger electrically connected to ground.

10. The method as set forth in claim 1 to 9, wherein
prior to short-circuiting said circuit array to be shorted the discrete circuits of said array are discretely short-circuit tested relative to each other.

## Revendications

1. Procédé de test de cartes de circuits imprimés comportant un grand nombre de pistes conductrices, dans lequel un groupe de pistes conductrices d'une carte de circuits imprimés est court-circuité en appliquant des doigts de test reliés électriquement entre eux, et, en appliquant une tension de test d'au moins 250 V sur le groupe de pistes conductrices, d'autres pistes conductrices sont testées en court-circuit par rapport à ce groupe de pistes conductrices.

2. Procédé selon la revendication 1, **caractérisé en ce que** les pistes conductrices court-circuitées par les doigts de test présentent une inductance d'au moins 0,1 mH.

3. Procédé selon la revendication 1, **caractérisé en ce que** les pistes conductrices court-circuitées par les doigts de test présentent une inductance d'au moins 1 mH.

4. Procédé selon l'une des revendications 1 à 3, **caractérisé en ce que** les pistes conductrices court-circuitées par les doigts de test présentent une capacité d'au moins 10 pF.

5. Procédé selon l'une des revendications 1 à 4, **caractérisé en ce que** les pistes conductrices court-circuitées par les doigts de test comportent au moins 10 points de contact.

6. Procédé selon l'une des revendications 1 à 5, **caractérisé en ce que** les pistes conductrices court-circuitées par les doigts de test présentent une capacité d'au moins 1 µF.

7. Procédé selon la revendication 1 ou 6, **caractérisé en ce que** les pistes conductrices court-circuitées par les doigts de test sont des pistes conductrices d'alimentation et/ou des pistes conductrices de masse.

8. Procédé selon l'une des revendications 1 à 7, **caractérisé en ce que** la tension de test est de 500 V.

9. Procédé selon l'une des revendications 1 à 8, **caractérisé en ce que** la tension de test par rapport à la masse est appliquée au groupe de pistes conductrices court-circuitées et les autres pistes conductrices sont testées avec un doigt de test relié électriquement à la masse.

10. Procédé selon l'une des revendications 1 à 9, **caractérisé en ce que**, avant de court-circuiter le groupe de pistes conductrices à court-circuiter, les pistes conductrices individuelles de ce groupe sont testées en court-circuit individuellement les unes par rapport autres.
